# EUROPÄISCHE PATENTSCHRIFT

(11) **EP 2 506 294 B1**
(45) Veröffentlichungstag und Bekanntmachung des Hinweises auf die Patenterteilung: **29.07.2015**
(21) Anmeldenummer: 12171753.2
(22) Anmeldetag: 13.08.2009
(51) Int. Cl.: H01L 21/311, H01L 21/3065, H01L 21/3213

(54) **Verfahren zum elektronenstrahlinduzierten Ätzen**
Method for electron beam induced etching
PROCÉDÉ DE GRAVURE INDUITE PAR FAISCEAU D'ÉLECTRONS

(30) Priorität: 14.08.2008 DE 102008037943
(43) Veröffentlichungstag der Anmeldung: 03.10.2012
(62) Teilanmeldung aus: 09777868.2
(73) Patentinhaber: Carl Zeiss SMT GmbH, 73447 Oberkochen (DE)
(72) Erfinder: Auth, Nicole, 65462 Gustavsburg (DE); Spies, Petra, 55130 Mainz (DE); Becker, Rainer, 64319 Pfungstadt (DE); Hofmann, Thorsten, 63110 Rodgau (DE); Edinger, Klaus, 64653 Lorsch (DE)
(74) Vertreter: Wegner, Hans

(56) Entgegenhaltungen:
- WO-A2-2007/100933
- DE-A1- 10 338 019
- US-A- 5 683 547
- RANDOLPH S J ET AL: "Focused, nanoscale electron-beam-induced deposition and etching", CRITICAL REVIEWS IN SOLID STATE AND MATERIALS SCIENCES, CRC PRESS, BOCA RATON, FL, US, Bd. 31, Nr. 3, 1. September 2006 (2006-09-01), Seiten 55-89, XP009098857, ISSN: 1040-8436

## Beschreibung

### 1. Technisches Gebiet

Die vorliegende Erfindung betrifft ein Verfahren zum elektronenstrahlinduzierten Ätzen.

### 2. Stand der Technik

Ätzprozesse spielen in der Industrie, insbesondere in der Halbleiterindustrie eine wichtige Rolle. Mit ihrer Hilfe werden feine Strukturen bis in den Nanometerbereich präpariert. Ätzprozesse haben ferner eine wichtige Funktion bei der Reparatur von Photolithographiemasken.

Für die Herstellung von feinen Strukturen mittels Ätzprozessen, wie sie in der Halbleitertechnologie verwendet werden, ist aus dem Stand der Technik das Ätzen unter Einwirkung eines fokussierten Ionenstrahls unter dem Akronym FIB (focused ion beam) bekannt. Die FIB Technologie ist beispielsweise in der US 4 639 301 offenbart. Der besondere Vorteil der FIB Technologie ist, dass sich damit sehr glatte und sehr steile Seitenwände, d.h. Strukturen mit großem Aspektverhältnis herstellen lassen. Das Aspektverhältnis bezeichnet das Verhältnis aus der Tiefe bzw. Höhe einer Struktur zu ihrer kleinsten lateralen Ausdehnung.

Die glatten Seitenwände der FIB Technologie beruhen darauf, dass der Materialabtrag bei dieser Technologie zum Teil nicht durch Ätzen sondern durch Sputtern mit dem fokussierten Ionenstrahl erfolgt. Die FIB Technologie weist jedoch schwerwiegende Nachteile auf. So führt die Sputterwirkung des Ionenstrahls dazu, dass auch Material außerhalb des zu ätzenden Bereichs abgetragen wird. Dieser Effekt wird in der US 6 753 538, als "riverbedding" Effekt beschrieben. Zum anderen werden - wie ebenfalls in der US 6 753 538 offenbart - Ionen in die Schicht unterhalb der zu ätzenden Schicht implantiert ("staining"), was deren Eigenschaften verändert bzw. diese Schicht schädigt. Zusätzlich lagert sich ein Großteil des gesputterten Materials an anderen Stellen auf der Probe oder in der Vakuumkammer wieder ab ("Redeposition").

Wird zum Induzieren des Ätzprozesses an Stelle eines Ionenstrahls ein Elektronenstrahl eingesetzt (electron beam induced etching, EBIE), erfolgt - wie in der US 6 753 538 offenbart - der Materialabtrag ausschließlich durch Ätzen. Der Sputteranteil, wie er bei der FIB Technik auftritt, verschwindet. In dem Artikel *"*Direct writing onto Si by electron beam stimulated etching" von S. Matsui und K. Mori (Appl. Phys. Lett. 51(19), 1498 (1987)) werden Untersuchungen zum Ätzen von Silizium mit dem Ätzgas Xenondifluorid (XeF₂) und gegebenenfalls mit einem zusätzlichem Elektronenstrahl vorgestellt. Durch den Einsatz des Elektronenstrahls verdoppelt sich die Ätzrate in Silizium im Vergleich mit der ausschließlichen Einwirkung des Ätzgases XeF₂. Die atomaren bzw. molekularen Vorgänge, die beim Ätzen von Silizium mit XeF₂ bzw. von verschiedenen Materialien mit verschiedenen Ätzgasen unter zusätzlicher Einwirkung von Korpuskularstrahlung ablaufen, wurden von J.W. Coburn und H.F. Winters untersucht (J.W. Coburn and H.F. Winters, "The etching of silicon with XeF2 vapor", Appl. Phys. Lett. 34(1), 70 (1979) und J.W. Coburn and H.F. Winters, "Ion and electron-assisted gas-surface chemistry - An important effect in plasma etching", J. Appl. Phys. 50(5), 3189 (1979)).

Die Offenlegungsschrift DE 103 38 019 A1 offenbart ein Verfahren zum Ätzen einer Chromschicht in einer Vakuumkammer mit den Schritten des Einleitens einer Halogen-Verbindung in die Vakuumkammer, des Richtens eines Elektronenstrahls auf den zu ätzenden Bereich der Chromschicht und des Einleitens einer sauerstoffhaltigen Verbindung in die Vakuumkammer. Das Einleiten der sauerstoffhaltigen Verbindung in die Vakuumkammer stellt sicher, dass hinreichend Sauerstoff für die Bildung der von der Oberfläche desorbierenden Reaktionsprodukte Cr O₂F₂ und CrOF₂ angeboten wird.

Das US Patent mit der Nr. 5 683 547 offenbart ein Bearbeitungsverfahren zum Ausführen einer lokalen Energiestrahlbearbeitung in einer von einem fokussierten Energiestrahl bestrahlten Fläche durch Bestrahlen einer Probe mit einem fokussierten Energiestrahl wie etwa einem Ionenstrahl oder einem Elektronenstrahl in einer Ätzgasatmosphäre. Als ein Ätzgas wird ein Mischgas verwendet, das in seiner Zusammensetzung von herkömmlichen Ätzgasen verschieden ist. Das Gas wird gleichmäßig an die Ätzfläche geliefert und zumindest einer der Bestandteile des Mischgases ist ein spontan reaktives Gas, das dazu verwendet wird, die Probe spontan und isotrop zu ätzen.

Das Dokument WO 2007/100933 A2 offenbart ein System und ein Verfahren zum Vergrößern der Ätzselektivität von Elektronenstrahlaktivierten chemischen Ätzen. Ein Target oder ein Teil davon wird einer Gaszusammensetzung ausgesetzt, wobei die Gaszusammensetzung so gewählt wird, dass sie das Target ätzt, wenn die Gaszusammensetzung und/oder das Target einem Elektronenstrahl ausgesetzt werden. Durch das Richten eines Elektronenstrahls auf das Target in der Umgebung der Gaszusammensetzung ätzt eine Wechselwirkung zwischen dem Elektronenstrahl und der Gaszusammensetzung einen Teil des Targets, der sowohl der Gaszusammensetzung als auch dem Elektronenstrahl ausgesetzt ist.

In dem Artikel *"*A New Side Wall Protection Technique in Microwave Plasma Eching Using a Chopping Method" von K. Tsujimoto et al. wurde beim Plasma-ätzen der Schutz von Seitenwänden durch wiederholtes Unterbrechen des Ätzvorgangs nach einer gewissen Zeit und sukzessives Aufbringen eines Nidridfilms untersucht (K. Tsujimoto, S. Tachi, K. Ninomiya, K. Suzuki, S. Okudaira and S. Nishimatsu, "A New Side Wall Protection Technique in Microwave Plasma Etching Using a Chopping Method", Conf. on Solid State Devices and Materials, 229-233, Tokyo 1986).

Beim elektronenstrahlinduzierten Ätzen wird zur Lösung des Problems des lateralen Ätzens ein Verfahren angewandt, das in der US 5 501 893 offenbart ist. Dabei wird - ähnlich wie in dem oben zitierten Artikel von K. Tsujimoto et al. der Ätzvorgang nach dem Abtrag von etwa 2 µm unterbrochen und die Seitenwände werden durch die Abscheidung von Polymere bildenden Materialien vor dem weiteren spontanen Ätzen geschützt. Danach wird dieser Prozess des abwechselnden Ätzens und Passivierens fortgesetzt, bis die gewünschte Ätztiefe erreicht ist.

Der wesentliche Nachteil dieses schrittweisen Ätz- und Passivierungsvorgangs liegt in der Bildung von Rippeln an den Seitenwänden. Während des ersten Ätzschritts tritt ein laterales Ätzen der Seitenwände auf, da die entstehenden Seitenwände noch nicht geschützt sind. Durch mehrmaliges Anwenden des Passivierungsschritts entsteht eine gerippelte Passivierungsschicht, deren Dicke von der Höhe abhängig ist, was die Steilheit und die Ebenheit der geätzten Seitenwände beeinträchtigt. Insbesondere bei kleinen Abmessungen der zu ätzenden Strukturen kann dies zu Problemen bei den nachfolgenden Prozessschritten führen.

Der Ausdruck spontanes Ätzen bedeutet in dieser Anmeldung das Ätzen eines Materials, das unter Einwirkung zumindest eines Ätzgases auftritt, ohne dass ein Elektronenstrahl auf das Material auftrifft.

Der vorliegenden Erfindung liegt daher das Problem zu Grunde, ein Verfahren zum elektronenstrahlinduziertem Ätzen anzugeben, das die oben genannten Nachteile zumindest zum Teil vermeidet.

### 3. Zusammenfassung der Erfindung

Gemäß einem Ausführungsbeispiel der vorliegenden Erfindung wird dieses Problem durch ein Verfahren nach Anspruch 1 gelöst. In einer Ausführungsform umfasst das Verfahren zum elektronenstrahlinduzierten Ätzen eines Materials das Bereitstellen zumindest eines Ätzgases an einer Stelle des Materials, an der ein Elektronenstrahl auf das Material trifft und das gleichzeitige Bereitstellen zumindest eines Passivierungsgases, das geeignet ist, ein spontanes Ätzen durch das zumindest eine Ätzgas zu verlangsamen oder zu unterbinden.

Überraschenderweise hat sich herausgestellt, dass beim elektronenstrahlinduzierten Ätzen die Zufuhr eines Passivierungsgases zum Ätzgas wirksam das spontane Ätzen unterdrückt. Damit kann auf die in der US 5 501 893 gelehrte Unterbrechung des Ätzprozesses zum sukzessiven Bilden eines Passivierungsfilms an den Seitenwänden verzichtet werden, wodurch sich das erfindungsgemäße Verfahren einfacher und damit mit geringerem Kostenaufwand durchführen lässt. Der besondere Vorteil des erfindungsgemäßen Verfahrens jedoch liegt darin, dass damit das spontane Ätzen an den Seitenwänden wirksam unterdrückt wird, ohne dass darauf eine Passivierungsschicht abgeschieden werden muss. Dadurch führt das erfindungsgemäße Verfahren zu sehr glatten Seitenwänden.

Insbesondere durch das gleichzeitige Bereitstellen eines Passivierungsgases kann spontanes Ätzen in verschiedenen zu ätzenden Materialien durch ein entsprechendes Einstellen des Partialdruckverhältnisses des Ätzgases und des Passivierungsgases unterdrückt werden.

In einer bevorzugten Ausführungsform des erfindungsgemäßen Verfahrens wird als Ätzgas Xenondifluorid (XeF₂) verwendet. Es ist jedoch denkbar andere Ätzgase einzusetzen, wie etwa Elemente aus der Gruppe der Halogene, also etwa Chlor (Cl₂), Brom (Br₂) oder Jod (I₂) oder weitere halogenhaltige Verbindungen.

In einer besonders bevorzugten Ausführungsform wird Ammoniak (NH₃) als Passivierungsgas eingesetzt. Das erfindungsgemäße Verfahren ist jedoch nicht auf die Verwendung von NH₃ als Passivierungsgas beschränkt. Es ist denkbar, andere Passivierungsmaterialien einzusetzen, wie etwa Stickstoff (N₂), Sauerstoff (O₂), Kohlenstoffdioxyd (CO₂), Kohlenstofftetrachlorid (CCl₄) und/oder Methan (CH₄).

Beim Ätzen von Silizium werden besonders gute Ergebnisse bei einem Gasmengenstrom des Passivierungsgases von 0,25 sccm (Standardkubikzentimeter pro Minute) erzielt.

In einer besonders bevorzugten Ausführungsform des erfindungsgemäßen Verfahrens umfasst das zu ätzende Material mehrere Schichten und weist die folgenden Prozessschritte auf: Bestimmen des Erreichens einer Schichtgrenze zwischen einer zumindest ersten und einer zumindest zweiten Schicht; und Anpassen des Bereitstellens des Passivierungsgases zum Verlangsamen oder Unterbinden des lateralen Ätzens in der zumindest zweiten Schicht.

Diese Ausführungsform ermöglicht es beim Ätzen durch mehrere übereinander liegende Schichten unterschiedlicher Materialien den Gasmengenstrom des Passivierungsgases so anzupassen, dass während des elektronenstrahlinduzierten Ätzens jeder einzelnen Schicht ein laterales Ätzen in der jeweiligen Schicht verlangsamt oder unterbunden wird. Damit erlaubt das erfindungsgemäße Verfahren das Präparieren von feinen Strukturen mit großem Aspektverhältnis über mehrere Schichten aus unterschiedlichen Materialien hinweg, ohne dass der EBIE Prozess unterbrochen werden muss. Bei einem Halbleiterbauelement wird damit das sogenannte "Circuit Editing" möglich, d.h. die gezielte Veränderung von mikroskopisch kleinen elektrischen Strukturen, indem Leiterbahnen des Bauteils nachträglich punktgenau durchtrennt oder miteinander verbunden werden.

In einer bevorzugten Ausführungsform wird das Erreichen einer Schichtgrenze durch das Auswerten eines Analysesignals bestimmt. In einem Ausführungsbeispiel umfasst ein Analysesignal das Detektieren von Sekundärelektronen, die von der gerade geätzten Oberfläche stammen. Zur Gewinnung eines Analysesignals können die bekannten Verfahren der Oberflächenanalyse verwendet werden, beispielsweise die Auger-Elektronenspektroskopie (AES), die Photoelektronenspektroskopie (XPS) oder die Massenspektroskopie. Denkbar ist in diesem Zusammenhang auch die Verwendung von bildgebenden Analyseverfahren wie die Elektronenstrahlmikroskopie, die Rastertunnelmikroskopie oder die Rasterkraftmikroskopie oder Kombinationen dieser Techniken.

In einer weiteren bevorzugten Ausführungsform wird das Erreichen einer Schichtgrenze durch die Messung der Ätzzeit bestimmt. Wenn die Ätzrate in Abhängigkeit von dem Ätzgas und dem Passivierungsgas für verschiedene Materialien in separaten Messungen bestimmt worden ist, kann für ein Schichtsystem mit bekannter Zusammensetzung der einzelnen Schichten und deren Dicken aus der Messung der Ätzzeit bestimmt werden, wann eine Schichtgrenze erreicht wird. Allerdings, können die beiden Alternativen Auswerten eines Analysesignals und Messen der Ätzzeit auch kombiniert werden.

Weitere Ausführungsformen des erfindungsgemäßen Verfahrens sind in weiteren abhängigen Patentansprüchen definiert.

### 4. Beschreibung der Zeichnungen

In der folgenden detaillierten Beschreibung werden derzeit bevorzugte Ausführungsbeispiele der Erfindung unter Bezugnahme auf die Zeichnungen beschrieben, wobei
- Fig. 1: eine schematische Darstellung zur Durchführung des Verfahrens gemäß eines ersten Aspekts der Erfindung zeigt, wobei ein in einer Vakuumkammer befindliches Material durch die kombinierte Einwirkung eines Ätzgases, eines Passivierungsgases und eines fokussierten Elektronenstrahls geätzt werden kann;
- Fig. 2: einen schematischen vergrößerten Schnitt durch ein in Silizium geätzten Zugangsloch nach einem ersten Aspekt der Erfindung zeigt;
- Fig. 3: eine schematische Darstellung zur Durchführung des Verfahrens gemäß eines zweiten Aspekts der Erfindung zeigt, wobei in der Vakuumkammer der Fig. 1 zusätzlich ein Detektor für von dem Elektronenstrahl rückgestreute Elektronen oder von dem Elektronenstrahl ausgelöste Sekundärelektronen angeordnet ist und das zu ätzende Material mehrere Schichten (Mehrschichtsystem) umfasst;
- Fig. 4: eine schematische vergrößerte Darstellung eines nach einem zweiten Aspekt der Erfindung geätzten Materials mit mehreren Schichten zeigt;
- Fig. 5: einen schematischen Schnitt durch das Via der Fig. 4 zeigt, wenn für eine Ätzung ein Verfahren des Standes der Technik verwendet worden ist; und
- Fig. 6: einen schematischen Schnitt durch das Via der Fig. 4 zeigt, wenn die Ätzung mit einem erfindungsgemäßen Verfahren durchgeführt worden ist.

### 5. Detaillierte Beschreibung bevorzugter Ausführungsbeispiele

Im Folgenden werden bevorzugte Ausführungsformen des erfindungsgemäßen Verfahrens und der erfindungsgemäßen Vorrichtung genauer erläutert.

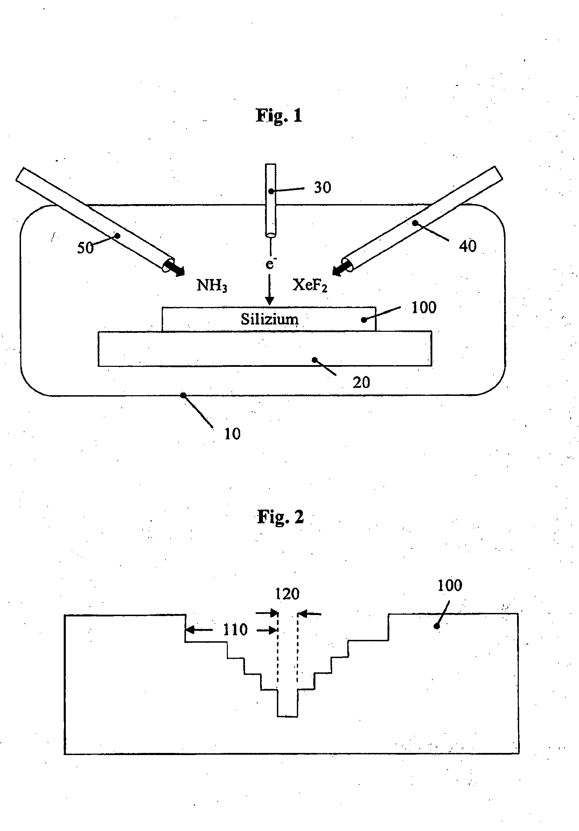

Wie in Fig. 1 schematisch dargestellt, wird in einer Vakuumkammer 10, beispielsweise eines für die Durchführung des erfindungsgemäßen Verfahrens angepassten Elektronenstrahlgeräts 30, beispielsweise eines Elektronenmikroskops, eine zu ätzende Siliziumschicht 100 auf einem Probenhalter 20 angeordnet.

In dem in Fig. 1 schematisch dargestellten bevorzugten Ausführungsbeispiel der vorliegenden Erfindung wird als Ätzgas XeF₂ über den Einlass 40 bzw. die Einlassdüse 40 in die Vakuumkammer 10 gelassen. Neben XeF₂ kommen auch andere Halogene in Betracht, beispielsweise Cl₂, Br₂ und I₂ oder halogenhaltige Verbindungen, wie z.B. SF₆. Das erfindungsgemäße Verfahren ist nicht auf die Verwendung von halogenhaltigen Verbindungen beschränkt. Denkbare weitere Ätzgase sind Stickstoffmonoxid (NO), Stickstoffdioxid (NO₂) oder andere stark oxidierende Substanzen. Das erfindungsgemäße Verfahren lässt ferner den gleichzeitigen Einsatz von mehr als einem Ätzgas zu. Deren Mischungsverhältnis kann sich zudem während des Ätzprozesses ändern.

Das Passivierungsgas NH₃ wird in der in Fig. 1 präsentierten Ausführungsform über den Einlass 50 in die Vakuumkammer 10 eingeleitet. Neben NH₃ können auch N₂, O₂, CO₂, CCl₄ und/oder CH₄ als Passivierungsgas zum Einsatz kommen. Als Passierungsgase sind alle Materialien denkbar, die an der Oberfläche des zu ätzenden Materials (d.h. an den Seitenwänden und der Bodenfläche) mögliche Adsorptionsplätze besetzen können und damit das Ätzgas davon verdrängen können. Das Passivierungsgas kann von zwei oder mehreren Gasen bzw. Materialien gebildet werden und deren Mischungsverhältnis kann sich im Laufe des Ätzprozesses ändern.

Sowohl XeF₂ als auch NH₃ werden über geeignete Dosierventile (in Fig. 1 nicht dargestellt) durch die entsprechenden Einlässe 40, 50 auf den zu ätzenden Bereich der Siliziumschicht 100 aufgebracht. Dabei ist es möglich die beiden Gase XeF₂ und NH₃ über getrennte Dosierventile aber einen gemeinsamen Einlass zu zuführen (in Fig. 1 nicht dargestellt). Alternativ zu einem auf die zu ätzende Oberfläche gerichteten Gaseineinlass, können das Ätzgas und/oder das Passivierungsgas auch ungerichtet in die Vakuumkammer 10 eingelassen werden.

Die Dosierungen von XeF₂ und NH₃ können zeitlich konstant sein. Es ist ferner möglich die Dosierungen der beiden Gase und/oder eines der beiden Gase während des Ätzprozesses zeitlich zu ändern ("chopping").

Die genauen Dosierungsverhältnisse des Ätzgases und des Passivierungsgases hängen maßgeblich von der Geometrie der Vakuumkammer 10, der Pumpleistung der verwendeten Vakuumpumpen sowie der geometrischen Anordnung des bzw. der Gaseinlässe 40 und 50 ab. Im Allgemeinen werden die Partialdrucke der beiden Gase oder deren Gasmengenströme so eingestellt, dass der Partialdruck des Passivierungsgases kleiner als der Partialdruck des Ätzgases ist.

Neben dem Mischungsverhältnis von Ätzgas und Passivierungsgas spielt der Elektronenstrahl bei dem EBIE Prozess die Hauptrolle. Für das erfindungsgemäße Verfahren werden vorzugsweise Elektronenenergien zwischen 0,1 keV und 30 keV abhängig von dem zu ätzenden Material eingesetzt. Dabei ist die Energie des Elektronenstrahls ein denkbarer Parameter zur Optimierung des erfindungsgemäßen Verfahrens. Ein weiterer den Ätzprozess kennzeichnender Parameter ist die Größe des Elektronenstroms, der angibt, wie viele Elektronen pro Zeiteinheit auf die Materialoberfläche auftreffen. In dem in Fig. 2 angegebenen Ätzprofil liegt der Elektronenstrom zwischen 50 pA und 200 pA.

Um die an der Oberfläche ablaufenden Prozesse durch den Elektronenstrahl optimal zu unterstützen, wird der Strahl in mehreren wiederholten Schritten über das zu ätzende Material geführt. Die Zeitspanne bis der Elektronenstrahl wieder an die vorher bearbeitete Stelle zurückkommt ("Refresh time") wird vorzugsweise so eingestellt, dass diese Stelle der Ätzoberfläche wieder ausreichend mit neuen, zur Reaktion benötigten Molekülen aus den Einlässen 40 und 50 versorgt ist. Die Dwell time beschreibt die Zeitdauer, die der Elektronenstrahl an jedem einzelnen Punkt verbleibt. Bei einem typischen Prozess beträgt die Dwell time einige 10 Nanosekunden, beispielsweise 50 ns, die Refresh time liegt in dem Bereich von einigen Millisekunden, beispielsweise bei 2 ms. Zusätzlich kann es sinnvoll sein, abhängig von der Größe der zu bearbeitenden Region den Strom des Elektronenstrahls und den Abstand aufeinanderfolgender Pixel zu variieren. Bei kleinen zu ätzenden Flächen sind beispielhafte Ströme im Bereich von 50 pA und weisen einen beispielhaften Pixelabstand von 2 nm auf. Große Flächen werden hingegen beispielsweise mit einem Elektronenstrom im Bereich von etwa 200 pA und einem Pixelabstand von etwa 4 nm bearbeitet.

Zur Initialisierung der Ätzreaktion wird vorzugsweise ausschließlich ein fokussierter Elektronenstrahl verwendet. Allerdings könnten zusätzlich oder alternativ auch andere energieübertragende Mechanismen zum Einsatz kommen (z.B. ein fokussierter Laserstrahl und/oder ein unfokussierter Ionenstrahl).

Die Größe der spontanen Ätzrate eines Ätzgases hängt ganz wesentlich von dem zu ätzenden Material ab. Dies bedeutet, dass bei einem elektronstrahlinduzierten Ätzen beispielsweise eines tiefen Grabens die Auswirkung spontanen Ätzens auf die zu ätzende Struktur eine Abhängigkeit von dem zu ätzenden Material aufweisen kann.

Das mit dem erfindungsgemäßen Verfahren zu ätzende Material ist nicht eingeschränkt. So können Materialien aus den Klassen der Metalle, der Halbleiter und/oder der Isolatoren geätzt werden. Ebenso können Materialien, die sich aus Kombinationen der verschiedenen Klassen zusammensetzen mit dem erfindungsgemäßen Ätzverfahren ebenfalls abgetragen werden. Verschiedene Materialien weisen verschiedene spontane Ätzraten gegenüber einem bestimmten Ätzgas auf, insbesondere wenn sie aus verschiedenen Klassen stammen. Jedes Material erfordert ein spezifisches Einstellen des Verhältnisses der Gasmengenströme von Passivierungsgas und Ätzgas. Beim Ätzen von metallisch leitfähigen Schichten, deren Metalle durch das Passivierungsgas beeinträchtigt werden könnten, kann es vorteilhaft sein, die Zufuhr von bestimmten Passivierungsgasen zu unterbrechen.

Gemäß eines ersten Aspekts wird das Verfahren zunächst an dem Beispiel des Ätzens einer Siliziumschicht beschrieben. Die Fig. 2 zeigt ein mit dem erfindungsgemäßen Verfahren in Silizium geätztes Zugangsloch. Wie aus dem bereits zitierten Artikel von S. Matsui und K. Mori bekannt ist ("Direct writing onto Si by electron beam stimulated etching", Appl. Phys. Lett. 51(19), 1498 (1987)), ätzt das Gas XeF₂ bereits ohne Elektronenbeschuss Silizium mit einer Rate von 7 nm/min. Durch die zusätzliche Einwirkung eines Elektronenstrahls verdoppelt sich die Ätzrate auf 14 nm/min. Dies bedeutet das Verhältnis von spontaner Ätzrate zu durch Elektronenstrahlung induzierter Ätzrate beträgt in Silizium 1:1, d.h. Silizium kann alleine durch das Ätzgas XeF₂ spontan und damit isotrop mit großer Ätzrate abgetragen werden. Damit ist Silizium ein geeignetes Material, um die Vorzüge des erfindungsgemäßen Verfahrens zu demonstrieren.

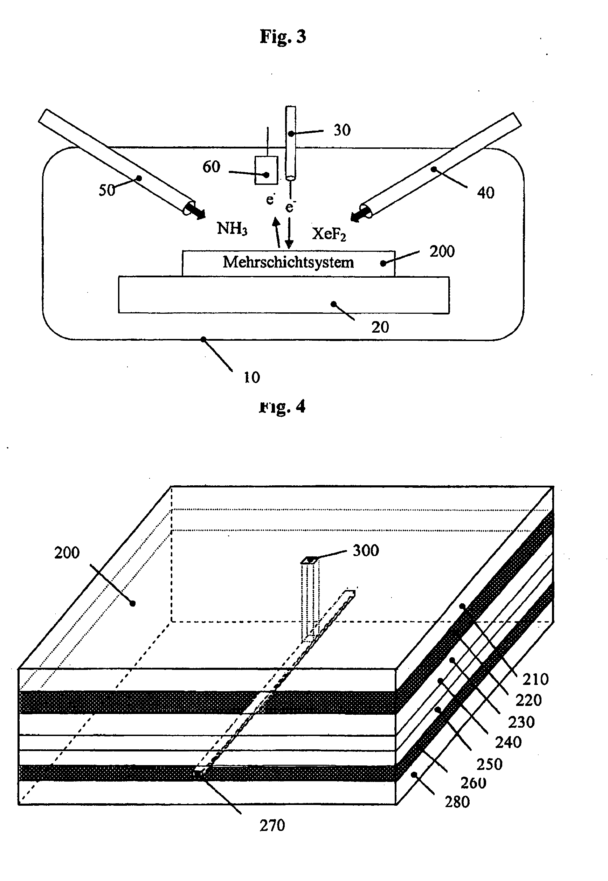

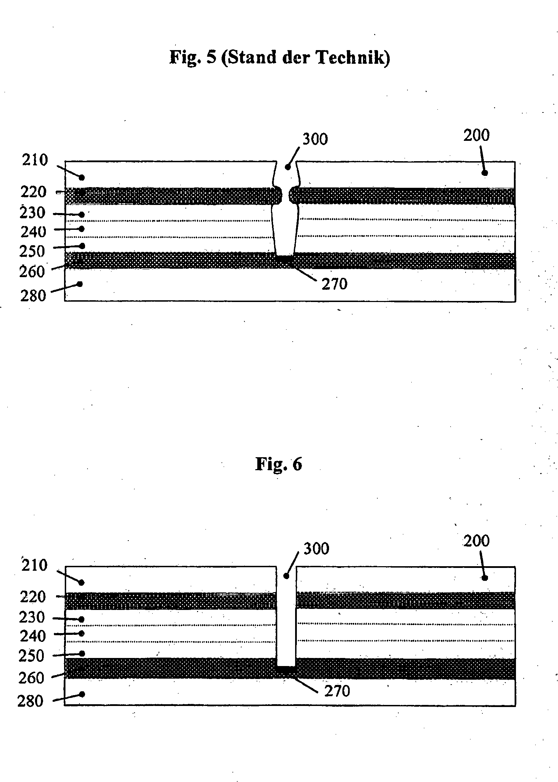

Das in der Fig. 2 dargestellte Zugangsloch in dem Siliziummaterial 100 wird in mehreren Schichten mit kleiner werdender Fläche abgetragen. Dabei können die Elektronenstrahlparameter wie oben beschrieben variiert werden. Es kann ferner notwendig sein, das Mischungsverhältnis zwischen Ätzgas und Passivierungsgas abhängig von der Größe der zu bearbeitenden Fläche und dem zu bearbeitenden Material anzupassen. So kann beispielsweise Silizium mit einem Mischungsverhältnis von 1:1 zwischen Ätz- und Passivierungsgas bei einem Gasmengenstrom im Bereich von 0,25 sccm geätzt werden. Bei anderen Materialien, beispielsweise beim Ätzen der in den Figuren 4 und 6 gezeigten Vias, können Mischungsverhältnisse mit weniger Passivierungsgas günstiger sein, wie beispielsweise ein Verhältnis von 1:5 bei Gasmengenströmen etwa 0,1 sccm für das Passivierungsgas und etwa 0,5 sccm für das Ätzgas.

Die glatten steilen Seitenwände der Fig. 2 zeigen, dass das erfindungsgemäße Verfahren selbst eine spontane Ätzrate wirksam unterdrücken kann, die genau so groß wie die durch den Elektronenstrahl induzierte Ätzrate ist. Damit wird verhindert, dass das Ätzgas XeF₂ spontan Silizium an Stellen abträgt, an denen kein Elektronenstrahl vorhanden ist.

Das Passivierurigsgas unterdrückt nicht nur das spontane Ätzen in lateraler Richtung, sondern auch zumindest teilweise den Beitrag des spontanen Ätzens in E-lektronenstrahlrichtung, also in vertikaler Richtung in Fig. 1. Dadurch kann die Ätzrate in vertikaler Richtung verringert werden, insbesondere für Gasmengenströme des Passivierungsgases die in den Bereich des Gasmengenstroms des Ätzgases kommen. Die Anwendung des erfindungsgemäßen Verfahrens auf Silizium 100 ermöglicht allerdings noch immer eine für eine wirtschaftliche Anwendung hinreichende Ätzrate, so dass Volumina von mehreren µm³ in Silizium 100 abgetragen werden können.

Die Fig. 3 zeigt einen zweiten Aspekt eines Ausführungsbeispiels des erfindungsgemäßen Verfahrens und der erfindungsgemäßen Vorrichtung. Sie weist gegenüber der Fig. 1 zwei wesentliche Änderungen auf. Zum einen ist auf dem Probenhalter 20 ein Material angebracht, das mehrere Schichten aufweist, das Mehrschichtsystem 200, und zum anderen ist ein Detektor 60 für aus dem Elektronenstrahl rückgestreute Elektronen und von dem Elektronenstrahl ausgelöste Sekundärelektronen in der Vakuumkammer 10 angeordnet. Anhand des Signals des Detektors 60 können Änderungen der Materialzusammensetzung der gerade geätzten Schicht im Vergleich zur nächsten Schicht detektiert werden. Damit kann durch die Auswertung des Signals des Detektors 60 bestimmt werden, dass in dem Mehrschichtsystem 200 eine erste Schicht abgetragen ist und der Ätzprozess mit dem Abtrag einer zweiten Schicht beginnt. Mit anderen Worten ermöglicht das Signal des Detektors 60 zu ermitteln, dass beim Ätzen eine Schichtgrenze erreicht ist.

Wie bereits während der Diskussion der Fig. 2 angesprochen, benötigt jedes zu ätzende Material ein spezifisches Verhältnis der Gasmengenströme von Passivierungsgas und Ätzgas. Ist der bereitgestellte Gasmengenstrom an Passivierungsgas im Verhältnis zu dem Gasmengenstrom des Ätzgases zu gering, wird spontanes Ätzen in dieser Schicht nicht vollständig unterbunden und ein Abtrag der Seitenwände wird nicht vollständig unterdrückt. Ist hingegen das Verhältnis der Gasmengenströme von Passivierungsgas zu Ätzgas in der zu ätzenden Schicht zu groß, so kann unnötigerweise die vertikale Ätzrate verringert werden. Im Extremfall ist ein Ätzprozess in einer Schicht nicht mehr möglich.

Die Detektion der Änderung in der Materialzusammensetzung der zweiten Schicht 220 beim Erreichen der Schichtgrenze zwischen der ersten 210 und der zweiten Schicht 220 mit Hilfe beispielsweise des in Fig. 3 dargestellten Detektors 60 erlaubt es, das Verhältnis der Gasmengenströme der beiden Gase NH₃ und XeF₂ für die nun zu ätzende zweite Schicht 220 neu einzustellen und somit an die spezifischen Erfordernisse des Unterbindens der spontanen Ätzrate der zweiten Schicht 220 anzupassen. Das Erreichen weiterer Schichtgrenzen kann aus den Signalen des Detektors 60 ebenfalls entnommen werden. Somit kann für ein beliebiges Mehrschichtsystem 200 für jede einzelne Schicht 210 bis 280 das Verhältnis der Gasmengenströme von Passivierungsgas und Ätzgas optimiert werden.

In der Fig. 4 ist schematisch dargestellt, wie in dem Mehrschichtsystem 200 durch mehrere Schichten 210 bis 260 ein Via 300 auf eine metallisch leitende Verbindung 270 freigeätzt wird, wobei das Verhältnis der Gasmengenströme NH₃ und XeF₂ an der Schichtgrenze der neu zu ätzenden Schicht angepasst wird. Die oberste Schicht 210 ist eine dielektrische Schicht, die wie die meisten Isolatoren von XeF₂ nicht spontan geätzt wird. Deshalb wird die Schicht 210 ohne Zufuhr von NH₃ abgetragen. Die Schichten 220, 230, 240 und 250 sind Halbleiterschichten verschiedener Zusammensetzung und Dicken. Hat der Ätzprozess nun die Schicht 210 abgetragen, d.h. die Ätzfront erreicht die Schichtgrenze zwischen den Schichten 210 und 220, so wird dies unmittelbar in dem Signal des Detektors 60 festgestellt. Aus dem Signal des Detektors 60 lässt sich ferner die Materialzusammensetzung der Schicht 220 ermitteln. Das Dosierventil für die NH₃ Zufuhr wird nun soweit geöffnet, dass der resultierende NH₃ Gasmengenstrom das spontane Ätzen in der Schicht 220 unterdrückt. Wie bereits oben erwähnt kann sich hier ein Mischungsverhältnis von etwa 1:5 bei Gasmengenströmen im Bereich von 0,1 sccm für das Passivierungsgas und von 0,5 sccm für das Ätzgas für das Ausführen des erfindungsgemäßen Verfahrens als günstig erweisen.

In dem Beispiel der Fig. 4 wird das nachfolgende System halbleitender Schichten 230, 240 und 250 mit dem gleichen Verhältnis der Gasmengenströme NH₃ zu XeF₂ wie der Schicht 220 geätzt. Das erfindungsgemäße Verfahren erlaubt jedoch ― wie auf der vorhergehenden Seite erläutert - den NH₃ Gasmengenstrom für jede der Schichten 230, 240 und 250 individuell anzupassen.

Die Barriereschicht 260 um die metallisch leitfähige Schicht 270 besteht ähnlich wie die Schicht 210 aus einem Material, das von XeF₂ spontan nicht geätzt wird. Deshalb wird, nachdem anhand des Signals des Detektors 60 festgestellt wurde, dass die Ätzfront die Grenze zwischen den Schichten 250 und 260 erreicht hat, das Dosierventil für die NH₃ Zufuhr geschlossen. Da die Kupferoberfläche der metallisch leitenden Schicht 280 Schaden nehmen könnte, wenn sie mit NH₃ in Berührung kommt, wird das Passivierungsgas aus der Vakuumkammer 10 abgepumpt. Der Abtrag der Schicht 270 erfolgt durch das Ätzgas unter Einwirkung des Elektronenstrahls analog zu dem Ätzen der dielektrischen Schicht 210. Das Auftrennen der metallisch leitenden Verbindung 270 geschieht ebenfalls unter der kombinierten Einwirkung des Ätzgases und des Elektronenstrahls. Das Mehrschichtsystem 200 mit der Schichtfolge 210 bis 270 ist auf dem halbleitenden Substrat 280 aufgebracht.

Die kleinst mögliche zu ätzende Fläche wird durch den Durchmesser des Elektronenstrahls bestimmt. Der Strahldurchmesser des Elektronenflusses kann eingestellt werden, insbesondere kann der Elektronenstrahl sehr fein fokussiert werden (Durchmesser < 4 nm). Damit kann die zu ätzende Fläche, als die von dem Elektronenstrahl beleuchtete Fläche, sehr klein gewählt werden. Dies eröffnet die Möglichkeit mit dem erfindungsgemäßen Verfahren durch Unterdrückung der spontanen Ätzrate sehr feine Strukturen mit großem Aspektverhältnis und glatten Seitenwänden zu präparieren.

Die Figuren 5 und 6 verdeutlichen nochmals einen wesentlichen Vorteil des erfindungsgemäßen Verfahrens. Die Fig. 5 zeigt einen vergrößerten Ausschnitt eines nach dem Stand der Technik durch die Schichtfolge der Fig. 4 geätzten Vias 300. Durch die unterschiedlichen Ätzraten in den Halbleiterschichten 210, 230, 240, 250 einerseits und den Isolatorschichten 220 und 260 andererseits tritt in der Schicht 220 eine Engstelle auf und in der darüber liegenden 210 und der darunter liegenden Schicht 230 eine Aufweitung des Vias 300 auf. Zum Ätzen des Vias 300 durch die Schichtfolge 210 bis 270 der Fig. 4 wurde in der Fig. 6 das erfindungsgemäße Verfahren eingesetzt. Die im Wesentlichen glatten und senkrechten Seitenwände des Vias 300 erleichtern die weiteren Prozessschritte nach dem Ätzprozess.

## Patentansprüche

1. Verfahren zum elektronenstrahlinduzierten Ätzen eines Materials (100, 200), aufweisend:
a. Bereitstellen zumindest eines Ätzgases an einer Stelle des Materials (100, 200), an der ein Elektronenstrahl auf das Material (100, 200) trifft;
b. gleichzeitiges Bereitstellen zumindest eines Passivierungsgases, das geeignet ist, spontanes Ätzen durch das zumindest eine Ätzgas zu verlangsamen oder zu unterbinden, wobei das Passivierungsgas Ammoniak (NH₃), Stickstoff (N₂), Sauerstoff (O₂), Kohlenstoffdioxid (CO₂), Kohlenstofftetrachlorid (CCl₄) und/oder Methan (CH₄) umfasst; und
c. Einstellen eines Partialdruckverhältnisses von Passivierungsgas und Ätzgas zum Unterbinden des spontanen Ätzens des Materials (100, 200).

2. Verfahren nach Anspruch 1, wobei das Ätzgas Xenondifluorid umfasst.

3. Verfahren nach einem der Ansprüche 1 oder 2, wobei das Bereitstellen des Passivierungsgases während des Ätzens des Materials (100, 200) kontinuierlich erfolgt oder variiert wird.

4. Verfahren nach einem der vorhergehenden Ansprüche, wobei das Material (100, 200) eine Siliziumschicht (100) umfasst.

5. Verfahren nach einem der vorgehenden Ansprüche, wobei das Partialdruckverhältnis von Passivierungsgas und Ätzgas an der Stelle des Auftreffens des Elektronenstrahls auf das Material (100, 200) kleiner oder gleich eins ist.

6. Verfahren nach einem der vorhergehenden Ansprüche, wobei das Passivierungsgas mit 0,25 Standardkubikzentimeter pro Minute bereitgestellt wird.

7. Verfahren nach einem der vorhergehenden Ansprüche, wobei das Material (100, 200) mehrere Schichten (200) umfasst, ferner aufweisend:
a. Bestimmen des Erreichens einer Schichtgrenze zwischen einer zumindest ersten Schicht (210) und einer zumindest zweiten Schicht (220); und
b. Anpassen des Bereitstellens des Passivierungsgases zum Verlangsamen oder Unterbinden lateralen Ätzens in der zumindest zweiten Schicht (220).

8. Verfahren nach Anspruch 7, wobei das Erreichen einer Schichtgrenze durch Auswerten eines Analysesignals bestimmt wird, wobei das Analysesignal ein Signal umfasst, das durch Detektieren von rückgestreuten Elektronen und/oder Sekundärelektronen gewonnen wird.

9. Verfahren nach Anspruch 7, wobei das Erreichen einer Schichtgrenze durch eine Messung der Ätzzeit bestimmt wird.

10. Verfahren nach einem der Ansprüche 7 - 9, wobei an einer Schichtgrenze der Partialdruck des Ätzgases angepasst wird.

11. Verfahren nach einem der Ansprüche 7 - 10, wobei das Verfahren zum Freiätzen von vergrabenen elektrisch leitfähigen Verbindungen (270) verwendet wird.

12. Verfahren nach einem der Ansprüche 7 - 11, wobei die Schichten (200) zumindest eine dielektrische Schicht (210, 260), zumindest eine Halbleiterschicht (220, 230, 240, 250, 280) und zumindest eine elektrisch leitfähige Schicht (270) umfassen.

13. Verfahren nach Anspruch 12, wobei während des Ätzens der Halbleiterschicht (220, 230, 240, 250, 280) Passivierungsgas mit 0,1 Standardkubikzentimeter pro Minute bereitgestellt wird.

14. Verfahren nach einem der Ansprüche 7 - 13, wobei das Bereitstellen des Passivierungsgases vor Erreichen einer Kupfer enthaltenden Schicht (270) unterbrochen wird und das Passivierungsmaterial aus der Vakuumkammer (10) entfernt wird.

## Claims

1. A method for electron beam induced etching of a material (100, 200), comprising:
a. providing at least one etching gas at a position of the material (100, 200) at which an electron beam impinges on the material (100, 200);
b. simultaneously providing at least on passivation gas which is adapted for slowing down or inhibiting spontaneous etching by the at least one etching gas, wherein the passivation gas comprises ammonia (NH₃), nitrogen (N₂), oxygen (O₂), carbon dioxide (CO₂), carbon tetrachloride (CCl₄) and / or methane (CH₄); and
c. adjusting a partial pressure ratio of the passivation gas and the etching gas for inhibiting the spontaneous etching of the material (100, 200).

2. Method according to claim 1, wherein the etching gas comprises xenon difluoride.

3. Method according to any one of claims 1 or 2, wherein the provision of the passivation gas occurs continuously during the etching of the material (100, 200) or is varied during the etching of the material (100, 200).

4. Method according to any one of the preceding claims, wherein the material (100, 200) comprises a silicon layer (100).

5. Method according to any one of the preceding claims, wherein the partial pressure ratio of the passivation gas and the etching gas at the position where the electron beam impinges on the material (100, 200) is smaller or equal to 1.

6. Method according to any one of the preceding claims, wherein the passivation gas is provided with 0.25 standard cubic centimeters per minute.

7. Method according to any one of the preceding claims, wherein the material (100, 200) comprises multiple layers (200), further comprising:
a. determining that a layer boundary between an at least first layer (210) and an at least second layer (220) is reached; and
b. adapting the provision of the passivation gas for slowing down or inhibiting lateral etching in the at least second layer (220).

8. Method according to claim 7, wherein the reaching of a layer boundary is determined by evaluating an analysis signal, wherein the analysis signal comprises a signal which is obtained by detecting back-scattered electrons and / or secondary electrons.

9. Method according to claim 7, wherein the reaching of a layer boundary is determined by a measurement of the etching time.

10. Method according to any one of claims 7 - 9, wherein the partial pressure of the etching gas is adjusted at a layer boundary.

11. Method according to any one of claims 7 - 10, wherein the method is used for etching a clearance hole in buried electrically conducting connections (270).

12. Method according to any one of claims 7 - 11, wherein the layers (200) comprise at least one dielectric layer (210, 260), at least one semiconductor layer (220, 230, 240, 250, 280) and at least one electrically conducting layer (270).

13. Method according to claim 12, wherein during the etching of the semiconductor layer (220, 230, 240, 250, 280) passivation gas is provided with 0.1 standard cubic centimeters per minute.

14. Method according to any one of claims 7 - 13, wherein the provision of the passivation gas is interrupted before reaching a copper containing layer (270) and the passivation gas is removed from the vacuum chamber (10).

## Revendications

1. Procédé de gravure induite par faisceau d'électrons d'un matériau (100, 200), comprenant :
a. fournir au moins un gaz de gravure en un point du matériau (100, 200) où un faisceau d'électrons frappe le matériau (100, 200) ;
b. fournir simultanément au moins un gaz de passivation apte à ralentir ou empêcher la gravure spontanée par le ou les gaz de gravure, le gaz de passivation comprenant de l'ammoniac (NH₃), de l'azote (N₂), de l'oxygène (O₂), du dioxyde de carbone (CO₂), du tétrachlorure de carbone (CCl₄) et/ou du méthane (CH₄) ; et
c. régler un rapport de pressions partielles du gaz de passivation et du gaz de gravure destiné à empêcher la gravure spontanée du matériau (100, 200).

2. Procédé selon la revendication 1, selon lequel le gaz de gravure comprend du difluorure de xénon.

3. Procédé selon l'une des revendications 1 ou 2, selon lequel la fourniture du gaz de passivation pendant la gravure du matériau (100, 200) s'effectue en continu ou de façon variable.

4. Procédé selon l'une des revendications précédentes, selon lequel le matériau (100, 200) comprend une couche de silicium (100).

5. Procédé selon l'une des revendications précédentes, selon lequel le rapport de pressions partielles du gaz de passivation et du gaz de gravure au point d'impact du faisceau d'électrons sur le matériau (100, 200) est inférieur et/ou égal à un.

6. Procédé selon l'une des revendications précédentes, selon lequel le gaz de passivation est fourni à un débit de 0,25 centimètre cube standard par minute.

7. Procédé selon l'une des revendications précédentes, selon lequel le matériau (100, 200) comprend plusieurs couches (200), comprenant en outre :
a. déterminer l'atteinte d'une limite de couche entre une au moins première couche (210) et une au moins deuxième couche (220) ; et
b. adapter la fourniture du gaz de passivation pour ralentir ou empêcher une gravure latérale dans ladite au moins deuxième couche (220).

8. Procédé selon la revendication 7, selon lequel l'atteinte d'une limite de couche est déterminée par évaluation d'un signal d'analyse, selon lequel le signal d'analyse comprend un signal qui est obtenu par détection d'électrons rétrodiffusés et/ou d'électrons secondaires.

9. Procédé selon la revendication 7, selon lequel l'atteinte d'une limite de couche est déterminée par une mesure du temps de gravure.

10. Procédé selon l'une des revendications 7 à 9, selon lequel la pression partielle du gaz de gravure est adaptée au niveau d'une limite de couche.

11. Procédé selon l'une des revendications 7 à 10, selon lequel le procédé est utilisé pour dégager par gravure des liaisons électroconductrices enterrées (270).

12. Procédé selon l'une des revendications 7 à 11, selon lequel les couches (200) comprennent au moins une couche diélectrique (210, 260), au moins une couche semi-conductrice (220, 230, 240, 250, 280) et au moins une couche électroconductrice (270).

13. Procédé selon la revendication 12, selon lequel, pendant la gravure de la couche semi-conductrice (220, 230, 240, 250, 280), le gaz de passivation est fourni à un débit de 0,1 centimètre cube standard par minute.

14. Procédé selon l'une des revendications 7 à 13, selon lequel la fourniture du gaz de passivation est interrompue avant l'atteinte d'une couche (270) contenant du cuivre, et le matériau de passivation est éliminé de la chambre à vide (10).
